# EUROPEAN PATENT APPLICATION

(11) **EP 1 383 364 A2**
(43) Date of publication of application: **21.01.2004**
(21) Application number: 03253126.1
(22) Date of filing: 19.05.2003
(51) Int. Cl.: H05K 3/12, H05K 3/38

(54) **Circuit elements having an ink receptive coating and a conductive trace and methods of manufacture**

(30) Priority: 23.05.2002 US 382728 P
(71) Applicant: Nashua Corporation, Nashua, NH 03063 (US)
(72) Inventor: Nelson, Richard A., Nashua, NH 03062 (US); Snow, Kenneth R., Bedford, NH 03110 (US); Menize, Robert R., Nashua, NH 03062 (US); Lochun, Darren, Milford, NH 03054 (US); Zeira, Eitan C., Hollis, NH 03049 (US)
(74) Representative: McKechnie, Neil

(57) **Abstract**

Disclosed is a circuit element including a substrate, a coating disposed on the substrate, and a conductive trace adjacent to the coating. The coating includes both pigment and hydrophobic binder. Also disclosed is a method for forming a circuit element. The method includes the steps of providing a substrate, disposing a coating that includes both a pigment and a hydrophobic binder on the substrate, and printing a conductive trace on the coating.

## Description

This application claims the benefit of and priority to U.S. Provisional Patent Application No. 60/382,728, filed on May 23, 2002, the entire disclosure of which is incorporated by reference herein.

### Field of the Invention

The present invention relates generally to circuit elements, and more specifically, to methods and apparatus for forming a circuit element on a coated substrate.

### Summary of the Invention

A novel approach to the manufacture of circuit elements has now been discovered. By practicing the disclosed invention, the skilled practitioner can construct novel circuit elements. The advantages of the present invention include more highly conductive traces that can withstand further use and processing such as plating and solder reflow.

In one aspect, the invention features a circuit element that includes a substrate, a coating disposed on the substrate, where the coating includes a pigment and a hydrophobic binder, and a conductive trace adjacent to the coating. The substrate can be formed of ethylene vinyl acetate, ethylene ethyl acetate, polyethylene, polyethylene terephthalate, polypropylene, polycarbonate, polyimide, polyethylene naphthalate, polyphenylene sulfide, polyester, polystyrene, and copolymers thereof, dielectric laminate, bisphenol A laminate, fiberglass laminate, paper, cellulosic paper, synthetic paper, metal, metal foils, glass, silica, silicate, and combinations thereof.

The coating disposed on the substrate includes both pigment and a hydrophobic binder. The pigment may be an acid resistant pigment. In one embodiment, the pigment may form about 10 weight percent to about 90 weight percent of the coating. In a particularly preferred embodiment, the pigment may form about 65 weight percent to about 85 weight percent of the coating. The pigment can be formed of clays, kaolin clays, calcined clays, calcium carbonate, silicate, silica, titanium dioxide, satin white, barium sulfate, and combinations thereof. In one embodiment, the coating includes a binder which may be formed of styrene butadiene rubber latex, polyvinyl alcohol, polyvinyl acetate, vinyl acetate-ethylene copolymers, polyvinyl ethylene, acrylics, and copolymers thereof, starch, protein, and combinations thereof.

The circuit element can include a conductive trace which is formed of a vehicle that is at least partially absorbed into the coating. The conductive trace may be formed of copper, silver, aluminum, carbon, intrinsically conductive polymer, polyacetylene, polyaniline, polypyrrole, polythiophene, and combinations thereof.

In one embodiment, the circuit element includes a conductive plating disposed on the conductive trace. In another embodiment, the circuit element includes a protective coating disposed on the surface of the circuit element.

In another aspect, the invention features a method of forming a circuit element. The method includes the steps of providing a substrate, disposing a coating on the substrate, where the coating includes a pigment and a hydrophobic binder, and printing a conductive ink on the substrate. The substrate can be formed of ethylene vinyl acetate, ethylene ethyl acetate, polyethylene, polyethylene terephthalate, polypropylene, polycarbonate, polyimide, polyethylene naphthalate, polyphenylene sulfide, polyester, polystyrene, and copolymers thereof, dielectric laminate, bisphenol A laminate, fiberglass laminate, paper, cellulosic paper, synthetic paper, metal, metal foils, glass, silica, silicate, and combinations thereof.

The coating includes both a pigment and a hydrophobic binder. The pigment can be an acid resistant pigment. In one embodiment, the pigment can form about 10 weight percent to about 90 weight percent of the coating. In a particularly preferred embodiment, the pigment can form about 65 weight percent to about 85 weight percent of the coating. The pigment can be formed of clays, kaolin clays, calcined clays, calcium carbonate, silicate, silica, titanium dioxide, satin white, barium sulfate, and combinations thereof. In one embodiment, the coating includes a binder which can be formed of styrene butadiene rubber latex, polyvinyl alcohol, polyvinyl acetate, vinyl acetate-ethylene copolymers, polyvinyl ethylene, acrylics, and copolymers thereof, starch, protein, and combinations thereof.

The step of printing conductive ink on the substrate can include printing a conductive ink which is formed of a conductive material and a vehicle. The conductive material can be formed of copper, silver, aluminum, carbon, intrinsically conductive polymer, polyacetylene, polyaniline, polypyrrole, polythiophene, and combinations thereof. In one embodiment, the vehicle is absorbed by the coating. In another embodiment, a conductive trace may be formed by drying the conductive ink. In yet another embodiment, the conductive trace may be plated. In yet another embodiment, the surface of the circuit element can be coated with a protective coating.

### Brief Description of the Drawings

The invention is pointed out with particularity in the appended claims. The drawings are not necessarily to scale, emphasis instead generally being placed upon illustrating the principles of the invention. The advantages of the invention can be better understood by reference to the description taken in conjunction with the accompanying drawings, in which:

**Figures 1A** and **1B** are a plan view and a cross-sectional side view taken along line B-B, respectively, of an exemplary circuit element formed in accordance with the present invention;

**Figure 2** is a schematic representation of an exemplary method of forming a circuit element of the present invention; and

**Figure 3** is another schematic representation of an exemplary method of forming a circuit element of the present invention.

### Detailed Description of the Invention

Disclosed herein are circuit elements that include a conductive trace and methods of their manufacture. One aspect of the present invention is directed to a circuit element including a conductive trace printed on a coating that is disposed on a substrate. The coating includes a pigment and a hydrophobic binder. Another aspect of the present invention is directed to methods of forming a circuit element.

It should be understood that the methods of the present invention can be used to create a conductive pattern on the surface of any circuit element including, but not limited to, conductors, resistors, capacitors, security tags, antennas, contacts, and lands. The circuit element can be or form part of a rigid, flexible or rigid-flex circuit layer. It can be incorporated into a single or double-sided circuit layer or assembly, a printed wiring board or wiring board assembly, or a multi-layer printed circuit or wiring board. In addition, methods of the present invention can be used to create conductive patterns on the surfaces of circuit elements to be used as internal and/or external circuit elements. The circuit elements of the present invention can be used in any application where circuit elements are used. Further, it should be understood that the invention encompasses the structure that is produced by the methods of the present invention.

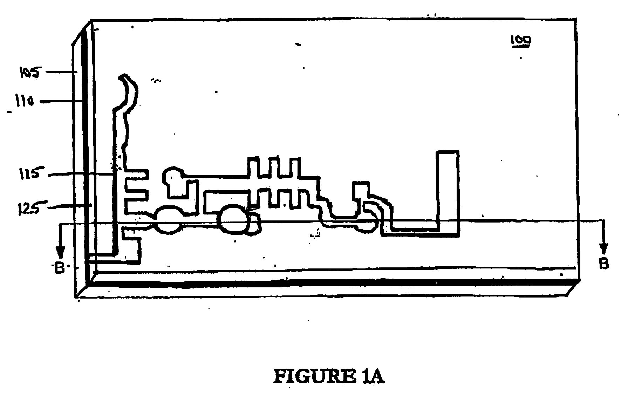

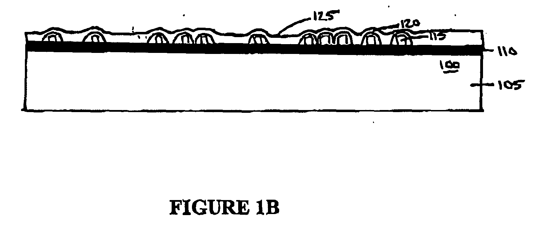

**Figures 1A** and **1B** are a plan view and a cross-sectional side view taken along line B-B, respectively, of an exemplary circuit element formed in accordance with the present invention. In general overview, the circuit element **100** includes a substrate **105**, a coating **110** disposed on the substrate, a conductive trace **115** adjacent to the coating, a conductive plating **120** adjacent to the trace, and a protective coating **125** disposed on the surface of the circuit element.

The substrate can include any substrate layer that can be used to construct a circuit element. The substrate layers can be provided as individual sheets so that they can be used in a sheet fed process, or as continuous sheets so that they can be processed in a reel to reel or roll to roll process. The substrate layers also can be provided as individual sheets adhered to a continuous film, *e.g.*, by adhesion, co-extrusion or lamination, for processing in a continuous fashion in a commercial printer. The substrate layers can be of any thickness. Preferably, the substrate layers are together thin and flexible enough to be printed in a commercial printer and otherwise processed in a continuous fashion.

The substrate may comprise multiple substrate layers which can be affixed together by various methods known in the art including, but not limited to, use of adhesives, coating including bar coating and hot melt coating, hot melt extrusion, laminating including heat laminating, and co-extrusion. In a preferred embodiment, the substrate layers are co-extruded. Further substrate layers additionally or alternatively can include internal layers, *e.g.*, dielectric layers such as conventional silica wafers, coated, printed, or laminated on both sides with a conductive material to provide desired mechanical or electrical properties. The substrate layers and/or multiple circuit elements of the present invention can be combined, *e.g.*, to form a multi-layer circuit board. The substrate layers can include a composite such as glass fiber or paper impregnated with epoxy resins. The substrate layers also can include other additives, *e.g.*, to improve fire retardancy, mechanical strength, thermal strength, and/or dielectric properties.

The substrate can be formed from any flexible substrate layer or layers including, but not limited to, ethylene vinyl acetate, ethylene ethyl acetate, polyethylene, polyethylene terephthalate, polypropylene, polycarbonate, polyimide, polyethylene naphthalate, polyphenylene sulfide, polyester, polystyrene and copolymers thereof. Additionally or alternatively, the substrate can be formed from dielectric laminate, *e.g.*, a bisphenol A (BPA)-based system commonly referred to as FR4, fiberglass laminate, paper, including cellulosic paper and synthetic paper, and combinations of the above materials. The substrate can include materials to increase mechanical strength, to adjust dielectric properties, and/or to render the substrate flame retardant. The substrate layers readily can be chosen by the skilled practitioner depending on the properties desired for the circuit element including any environmental requirements such as temperature stability or flexibility. For example, if it is desired to construct a circuit element requiring flexibility, tear resistance, and high temperature stability, a substrate layer formed from polyimide or polyethylene naphthalate can be employed. If it is desired to create a moisture barrier, a substrate that includes a metal or a metal foil layer can be employed.

A preferred substrate is ethylene vinyl acetate. Another preferred substrate is ethylene ethyl acetate. Suitable two-layer substrates include polyester substrates hot melt coated with ethylene vinyl acetate manufactured by General Binding Corporation (Skokie, IL), and commercially available from McIntire Business Products (Concord, NH). For example, the 5 mil product that includes a 3 mil polyester layer hot melt coated with a 2 mil ethylene vinyl acetate layer, and the 3 mil product that includes a 1 mil polyester layer hot melt coated with a 2 mil ethylene vinyl acetate layer, are suitable for use in accordance with the present invention. Suitable polyethylene naphthalate layers are available under the mark Kaladex® by I.E. du Pont de Nemours and Company (Circleville, OH). Suitable polyimide layers are available under the mark Kapton® by I.E. du Pont de Nemours and Company (Circleville, OH).

As mentioned above, the substrate can also be or include a synthetic substrate or synthetic paper layer. Synthetic papers include polymers that are ground or made into fibers and processed in a paper machine. Synthetic papers also include polymeric films that are blown or cast to form a planar film or substrate. Suitable synthetic papers for use in accordance with the circuit element and methods of the present invention include, but are not limited to, POLYART® clay coated polyethylene synthetic paper from Arjobex North America (Charlotte, NC), and TESLIN® silica and polyethylene synthetic printing sheets from PPG (Vernon Hills, IL).

Disposed upon the substrate is a coating that generally includes a pigment and a hydrophobic binder. The pigment can be formed of any pigment including, but not limited to, clays including kaolin clay and calcined clays, calcium carbonate, silicate, silica, titanium dioxide, satin white, barium sulfate, other pigments which may be used in paper or paint coatings, and combinations thereof. In one embodiment the pigment comprises from about 10% to about 90% of the coating by weight. In a preferred embodiment, the pigment comprises from about 65% to about 85% of the coating by weight. Preferably, the pigment is acid resistant, *e.g.*, calcined clay.

The hydrophobic binder can include any hydrophobic binder used to formulate inks, and can further include hydrophilic binders, *e.g.*, polyvinyl alcohol. Examples of suitable binders that can be used in accordance with the present invention are styrene butadiene rubber latex, polyvinyl alcohol, polyvinyl acetate, vinyl acetate-ethylene copolymers, polyvinyl ethylene, copolymers, starch, protein, acrylics, and combinations thereof. In one embodiment, the binder comprises from about 10% to about 90% of the coating by weight. In a preferred embodiment, the binder comprises from about 15% to about 35% of the coating by weight. In addition to the pigment and the hydrophobic binder, the coating may also include various additives including, but not limited to, defoamers, leveling aids and surfactants.

The conductive trace can be formed from a conductive ink printed upon the coating. Examples, of conductive traces include, but are not limited to, circuit board traces, touch pad elements, RFID tags, and printed resistors and capacitors. The conductive traces of the present invention can be conductive enough to carry current or they can be sufficiently conductive to carry or transmit a signal, such as for use as a touch pad element. The conductive traces of the present invention can be sufficiently conductive to facilitate electrolytic plating, if additional conductivity is desired.

The conductive trace is formed from conductive ink that is printed on the coating. The conductive ink can be formulated for printing onto the substrate using various printing processes. The conductive ink typically includes a plurality of conductive particles and a vehicle including one or more binders, carriers, additives, resins and/or solvents.

The conductive material can include silver, copper, gold, aluminum, palladium, platinum, carbon, intrinsically conductive polymers including polyacetylene, polyaniline, polypyrrole and polythiophene, and combinations of these particles. Generally, intrinsically conductive polymers are polymers that conduct electric currents without the addition of conductive substances. If conductive particles are used, the average particle size of the conductive material preferably is within the range of between about 0.5 µm and about 20 µm. More preferably the average particle size is between about 2 µm and about 5 µm. Even more preferably, the average particle size is about 3 µm. The amount of conductive material in the conductive trace preferably is between about 60% and about 90% on a dry weight basis. More preferably, the amount of conductive material in the conductive trace is between about 75% and about 85% on a dry weight basis.

Optionally, the conductivity of the trace can be increased if the conductive trace includes a particle size distribution of conductive particles that does not have a Gaussian or normal distribution but a particle size distribution having at least two modes, *e.g.*, bimodal and trimodal distributions. For example, a bimodal distribution of particles can increase the conductivity of the conductive trace because the smaller particles can fill in gaps between the larger particles and thereby decrease the distances over which electrons must travel between particles.

A bimodal distribution can be obtained, *e.g.*, by mixing two particle mixtures, each having different mean particle sizes. One suitable conductive ink includes a mixture of two types of silver particles, each having different particles size distributions. The first is available under the trade designation RA15 from Mettalor (Attleboro, MA), and has particles, 10% of which are equal to or less than 2.6 µm in size, 50% of which are equal to or less than 7.3 µm in size, and 90% of which are equal to or less than 16.3 µm in size. The second is available under the trade designation RA76 from Mettalor (Attleboro, MA), and has particles, 10% of which are equal to or less than 2.5 µm in size, 50% of which are equal to or less than 10.1 µm in size, 90% of which are equal to or less than 22.9 µm in size, and 100% of which are equal or less than 62.2 µm in size. Of course, the particle size distribution can be trimodal and so on.

The conductive particles can be flakes and/or powders. Preferably, the conductive flakes have a mean aspect ratio of between about 2 and about 50, and more preferably between about 5 and about 15. An aspect ratio is a ratio of the largest linear dimension of a particle to the smallest linear dimension of the particle. For example, the aspect ratio of an ellipsoidal particle is the diameter along its major axis divided by the diameter along its minor axis. For a flake, the aspect ratio is the longest dimension across the length of the flake divided by its thickness.

Suitable conductive flakes include those sold by Metalor (Attleboro, MA), under the following trade designations: P 185-2 flakes having a particle size distribution substantially between about 2 µm and about 18 µm; P264-1 and P264-2 flakes having particle size distributions substantially between about 0.5 µm and about 5 µm; P204-2 flakes having a particle size distribution substantially between about 1 µm and about 10 µm; P204-3 flakes having a particle size distribution substantially between about 1 µm and about 8 µm; P204-4 flakes having a particle size distribution substantially between about 2 µm and about 9 µm; EA-2388 flakes having a particle size distribution substantially between about 1 µm and about 9 µm; SA-0201 flakes having a particle size distribution substantially between about 0.5 µm and about 22 µm and having a mean value of about 2.8 µm; RA-0001 flakes having a particle size distribution substantially between about 1 µm and about 6 µm; RA-00 15 flakes having a particle size distribution substantially between about 2 µm and about 17 µm; and RA-0076 flakes having a particle size distribution substantially between about 2 µm and about 62 µm, and having a mean value of about 12 µm. Suitable silver powders include those sold by Metalor (Attleboro, MA), under the following trade designations: C-0083P powder having a particle size distribution'substantially between about 0.4 µm and about 4 µm, and having a mean value of about 1.2 µm; K-0082P powder having a particle size distribution substantially between about 0.4 µm and about 6.5 µm, and having a mean value of about 1.7 µm; and K-1321 P powder having a particle size distribution substantially between about 1 µm and about 4 µm.

The resin in the conductive ink can include any resin including, but not limited to, polymers, polymer blends, and fatty acids. Alkyd resins can be used, including LV-2190, LV-2183 and XV-1578 alkyd resins from Lawter International (Kenosha, WI). Also suitable are Crystal Gloss Metallic Amber resin, Z-kyd resin, and alkali refined linseed oil resin available from Kerley Ink (Broadview, IL). Soy resins available from Ron Ink Company (Rochester, NY), also are suitable.

Solvents for use in the conductive ink formulation are well known in the art and a skilled practitioner readily can identify a number of suitable solvents for use in a particular printing application. Solvents generally will comprise between about 3% and about 40% of the ink by weight on a wet basis. The amount will vary depending on various factors including the viscosity of the resin, the solvation characteristics of the solvent, and the conductive particle size, distribution and surface morphology for any given printing method. Generally, solvent can be added to the ink mixture until a desired ink rheology is achieved. The desired rheology depends on the printing method used, and are known by skilled printers and ink manufacturers. The solvent in the conductive ink can include non-polar solvents such as a hydrocarbon solvent, water, an alcohol such as isopropyl alcohol, and combinations thereof. Preferably, an aliphatic hydrocarbon solvent is employed. Examples of suitable solvents include Isopar H aliphatic hydrocarbon solvent from Exxon (Houston, TX); EXX-PRINT® M71 a and EXX-PRINT® 274a aliphatic and aromatic hydrocarbon solvent from Exxon Corporation (Houston, TX); and McGee Sol 52, McGee Sol 47 and McGee Sol 470 aliphatic and aromatic hydrocarbon solvent from Lawter International (Kenosha, WI).

Various ink additives known in the art, *e.g.*, antioxidants, leveling agents, flow agents and drying agents, may be included in the conductive ink. The conductive ink can be in the form of a paste, slurry or dispersion, and preferably is mixed in a grinding mill to sufficiently wet the conductive particles with the vehicle, *e.g.*, solvent and resin.

The conductive traces formed in accordance with the present invention can be formed at high resolutions and in intricate patterns. Printing presses have been used to print conductive traces that are capable of line widths and gaps of about 100 µm. It is envisioned that more intricate designs and smaller line widths can be achieved in accordance with the present invention depending on the printing equipment. The conductive trace can form or be part of an RFID tag, a printed wiring board, a printed circuit board, single layer or multi-layer, a passive component such as a resistor or capacitor, a touch pad, or the like. Numerous other applications, such as microwave antennas are contemplated by the present invention. The conductivity can be adjusted for various application, *e.g.*, to tune an antenna, or to form a resistor or capacitor.

The conductive traces of the present invention exhibit improved stability and conductivity versus traces printed directly onto substrates without coatings. Without wishing to be bound by any particular theory, it is believed that the vehicle in the ink infiltrates and/or is absorbed into the coating of the present invention. Thus, the conductive particles remaining on top of the coating have a greater density and/or contact with each other in the conductive trace promoting increased conductivity. Furthermore, upon evaporation of the solvent and solidification of the vehicle generally, there is greater adhesion between the conductive trace and the coating because the vehicle has infiltrated the coating. It has also been observed that there is an improvement in drying speed and print resolution when compared to circuit elements with uncoated substrates.

Optionally, the conductive trace can be plated. Electrolytic plating also is called electrolytic conductive plating or electroplating, which is the electrolytic deposition or electrodeposition of a conductive material from a plating solution by the application of electric current. Conductive plating is formed from a conductive plating material. Suitable conductive plating materials include, but are not limited to, copper, nickel, gold, silver, aluminum, palladium, carbon, intrinsically conductive polymers including polyacetylene, polyaniline, polypyrrole and polythiophene, and combinations thereof. The conductive plating is preferably formed by electrolytically plating the conductive traces. Methods of electrolytic plating are known in the art. Preferably the conductive material in the conductive traces are silver particles and the conductive traces are electroplated with copper. Additionally, other types of plating can be used, *e.g.*, electrochemical or electroless plating. Plating provides improved conductivity and also can provide the added benefit of bridging any small voids or gaps in the conductive trace.

Additionally or alternatively, the circuit element can be coated or plated with a protective coating to protect the conductive traces, the conductive plating and/or other elements of the circuit element from corrosion or other damage. For example, conductive traces can be plated with protective coating of nickel and/or a surface of the circuit element can be coated with a non-conductive polymeric layer to protect against environmental wear and tear. Suitable protective coating materials and methods of coating or plating are known in the art. Additionally or alternatively, both surfaces of the substrate can be coated with protective coatings. Such coatings can be present only on the conductive traces on predetermined sections of the circuit element or coat a surface of the circuit element.

Surface mounted devices can be incorporated into the circuit elements of the present invention. Such devices can be attached to the substrate layers by a pin, which can be affixed with solder, an electrically conductive adhesive, or the like. Solder or an electrically conductive adhesive and one or more vias also can facilitate electrical communication between devices and traces on both sides of the substrate. Additionally or alternatively, solder pads without vias can attach other surface mounted devices, and vias can be used to facilitate registration or communication between one or several substrates. Substrates can be stacked and even laminated to provide a multi-layer circuit board with surface mounted devices only on the outer layers. Various additional aspects of the circuit element, method of use, and method of manufacture of the present invention are described in U.S. Patent Application Serial No. 10/113,733 filed April 1, 2002, which is hereby incorporated by reference herein.

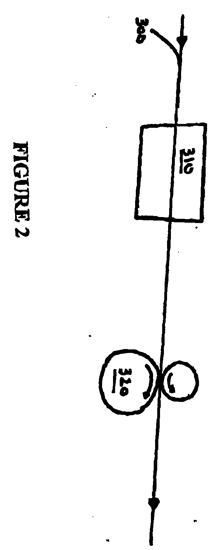

Another aspect of the present invention is a method of forming a circuit element. The method generally includes the steps of providing a substrate, disposing a coating on the substrate, wherein the coating includes a pigment and a hydrophobic binder, and printing a conductive ink on the substrate. **Figure 2** is a schematic representation of an exemplary method of forming a circuit element. The method generally includes providing a substrate **300**, applying a coating to the substrate surface using a coating device **310**, and printing a conductive ink onto the coating using a printer **320** to form one or more traces.

The substrate, the coating, and the conductive are as described above. The coating containing both pigment and hydrophobic binder may be applied to the surface of the substrate employing a variety of coating techniques known in the art, including hot melt coating, spray coating, bar coating, roll coating, gravure coating, rod coating or curtain coating. The substrate preferably is in web form so that it easily can be stored and shipped before and/or after it is incorporated into the circuit elements of the present invention, and so that it can readily be fed through a continuous process, *e.g.*, a roll to roll process or a sheet fed process.

The conductive ink can be applied to the coating using printing techniques known in the art for printing inks on paper and other substrates, including, but not limited to, offset-lithographic (wet, waterless and dry), flexographic, rotogravure (direct or offset), intaglio, ink jet, electrophotographic (laser jet and photocopy), and letterpress printing. These printing methods are desirable because conventional methods for forming traces on circuit boards include multiple steps, *e.g.*, photoresist, cure and etching, are time intensive, environmentally unfriendly, and relatively expensive. Commercial printing presses preferably are used for printing on the substrates of the present invention. Commercial printing presses may require additional drying capability to dry the ink after printing or require modifications to handle polymer films, *e.g.*, to handle electrostatic charge. These types of modifications are known in the art and typically can be ordered when purchasing a commercial printing press. Depending on the printing technology, printing speed in the range of from about 150 feet per minute to about 300 feet per minute readily can be achieved. It is envisioned that even greater printing speeds can be achieved, *e.g.*, about 1000 feet per minute or more. It also is envisioned that personal printers, *e.g.*, ink jet and laser jet printers, can be used to print conductive traces on substrates in accordance with the present invention.

The ink preferably is deposited in a quantity such that the dried conductive trace is from about 1 µm to about 8 µm thick depending on the printing process used. A single impression giving an ink film thickness of about 2 µm to about 3 µm typically is sufficient to achieve sufficient conductivity for plating. The conductive ink optionally can be printed on the substrate two or more times to deliver more conductive ink to the substrate. Conductive inks are commercially available and also can be readily made as known in the art and described herein.

The combination of ink receptive coating and conductive trace as opposed to merely a printed conductive trace, provides improved bonding or adhesion to the circuit element and is resistant to the rigorous conditions of further use and processing, such as, *e.g.*, electrolytic plating. The adhesion of a conductive trace and/or any plating thereon can be determined by a standard tape test where Scotch® adhesive tape is applied to the circuit element, peeled off, and optically inspected for transfer of the conductive trace or plating from the circuit element to the Scotch® adhesive tape. The tape exerts a peel force on the conductive trace and/or any plating thereon of approximately 6 lb/in (1050 N/m). An adhesion of about 5 to about 7 pounds per square inch generally is considered acceptable for most uses of circuit elements. However, adhesion of less than about 5 pounds per square inch is sufficient where plating is not required.

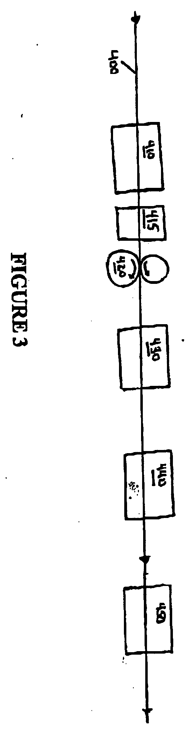

**Figure 3** is a schematic representation of another exemplary method of forming a circuit element of the present invention. The method generally includes providing a substrate layer **400**. A coating is then disposed onto the substrate using a coating device **410** and dried in oven **415**. Conductive ink then is printed onto the substrate using a printer **420**, and dried in an oven **430** to form one or more conductive traces. Subsequently, the conductive traces are plated in a plating bath **440**. Finally, a second coating device **450** applies a protective coating to a surface of the circuit element.

The steps of providing the substrate layer, coating the substrate, and printing the conductive ink are as described above. The coating can be dried, *e.g.*, in an oven to solidify the coating prior to printing the conductive ink. The conductive ink can be dried to drive off some or all of the solvent or carrier. The coating and conductive ink can be dried using ovens, such as convection ovens, and/or by using infrared or radio frequency drying. Preferably, the drying devices are designed to allow the circuit element to pass therethrough so that the coating and conductive ink can be dried in a continuous manner to facilitate large-scale production. The drying temperature employed depends on the formulation of the coating and ink used and the drying time or belt speed. Typical drying temperatures are from about 125°F to about 150°F. After the drying steps, the circuit element can be allowed to cool.

Where increased conductivity is desired, methods of the instant invention can further include the step of electrolytically plating the conductive traces, *e.g.*, with copper, to form conductive plating on the conductive trace. The conductive trace can be electrolytically plated using methods known in the art. Plating can also provide the added benefit of bridging any small voids or gaps in the conductive trace. Plated circuit elements of the present invention have demonstrated adhesion in excess of industry standards for further processing and use.

Surface mounted devices can be mounted on a circuit element of the present invention. For example, solder in the form of a paste or ink can be applied to the circuit element to form solder pads at predetermined places where devices are to be mounted by conventional methods such as screen printing with a mask, solder paste, and squeegee. The surface mounted devices then can be placed on the circuit element at predetermined places dictated by the circuit design. The circuit element then can be passed through a reflow oven or furnace to melt or reflow the solder. Reflow temperatures vary depending on the solder formula, and typically are provided for commercial solders. Generally, the solder reflow temperature is about 250°C. When the circuit element is removed from the furnace and cools, the solder hardens and the devices are affixed to the board at the solder pads.

The methods of the present invention can include the step of coating a surface of the circuit element with a protective coating. The protective coating can be a coating applied to an entire surface of the circuit element, a portion of the surface, or to the conductive traces and/ or plating only, using coating methods known in the art and described above.

If the circuit elements are packaged, a release, liner preferably is placed between each circuit element to prevent the transfer of the conductive traces or the substrate layers if either or both are tacky. Circuit elements can be bundled and wrapped in shrink-wrap to discourage movement and damage to the circuit elements.

Various additional aspects of the methods of forming a circuit element of the present invention are described in U.S. Patent Application Serial No. 10/113,733, filed April 1, 2002, which is hereby incorporated by reference herein in its entirety.

Throughout the description, where compositions are described as having, including, or comprising specific components, or where processes are described as having, including, or comprising specific process steps, it is contemplated that compositions of the present invention also consist essentially of, or consist of, the recited components, and that the processes of the present invention also consist essentially of, or consist of, the recited processing steps. Further, it should be understood that the order of steps or order for performing certain actions are immaterial so long as the invention remains operable. Moreover, two or more steps or actions may be conducted simultaneously.

## Claims

1. A circuit element comprising:
a substrate;
a coating disposed on the substrate, the coating comprising:
a pigment; and
a hydrophobic binder; and
a conductive trace adjacent to the coating.

2. The circuit element of claim 1 wherein the pigment comprises an acid resistant pigment.

3. The circuit element of claim 1 wherein the pigment comprises between about 10 weight percent and about 90 weight percent of the coating.

4. The circuit element of claim 1 wherein the pigment comprises between about 65 weight percent and about 85 weight percent of the coating.

5. The circuit element of claim 1 wherein the conductive trace comprises a vehicle and the vehicle is at least partially absorbed into the coating.

6. The circuit element of claim 1 wherein the pigment comprises a material selected from the group consisting of clays, kaolin clays, calcined clays, calcium carbonate, silicate, silica, titanium dioxide, satin white, barium sulfate, and combinations thereof.

7. The circuit element of claim 1 wherein the coating comprises a binder selected from the group consisting of styrene butadiene rubber latex, polyvinyl alcohol, polyvinyl acetate, vinyl acetate-ethylene copolymers, polyvinyl ethylene, acrylics, and copolymers thereof, starch, protein, and combinations thereof.

8. The circuit element of claim 1 wherein the substrate comprises a substrate layer selected from the group consisting of ethylene vinyl acetate, ethylene ethyl acetate, polyethylene, polyethylene terephthalate, polypropylene, polycarbonate, polyimide, polyethylene naphthalate, polyphenylene sulfide, polyester, polystyrene, and copolymers thereof, dielectric laminate, bisphenol A laminate, fiberglass laminate, paper, cellulosic paper, synthetic paper, metal, metal foils, glass, silica, silicate, and combinations thereof.

9. The circuit element of claim 1 wherein the conductive trace comprises a conductive material selected from the group consisting of copper, silver, aluminum, carbon, intrinsically conductive polymer, polyacetylene, polyaniline, polypyrrole, polythiophene, and combinations thereof.

10. The circuit element of claim 1 comprising a conductive plating disposed on the conductive trace.

11. The circuit element of claim 1 comprising a protective coating disposed on a surface of the circuit element.

12. A method of forming a circuit element, the method comprising the steps of:
providing a substrate;
disposing a coating on the substrate, the coating comprising:
a pigment; and
a hydrophobic binder; and
printing a conductive ink on the substrate.

13. The method of claim 12 wherein the pigment comprises an acid resistant pigment.

14. The method of claim 12 wherein the pigment comprises between about 10 weight percent and about 90 weight percent of the coating.

15. The method of claim 12 wherein the pigment comprises between about 65 weight percent and about 85 weight percent of the coating.

16. The method of claim 12 wherein the pigment comprises a material is selected from the group consisting of clays, kaolin clays, calcined clays, calcium carbonate, silicate, silica, titanium dioxide, satin white, barium sulfate, and combinations thereof.

17. The method of claim 12 wherein the coating comprises a binder selected from the group consisting of styrene butadiene rubber latex, polyvinyl alcohol, polyvinyl acetate, vinyl acetate-ethylene copolymers, polyvinyl ethylene, acrylics, and copolymers thereof, starch, protein, and combinations thereof.

18. The method of claim 12 wherein the conductive ink comprises:
a conductive material selected from the group consisting of copper, silver, aluminum, carbon, intrinsically conductive polymer, polyacetylene, polyaniline, polypyrrole, polythiophene, and combinations thereof; and
a vehicle.

19. The method of claim 18 wherein at least a portion of the vehicle is absorbed by the coating.

20. The method of claim 12 comprising the step of providing a substrate wherein the substrate comprises a substrate layer selected from the group consisting of ethylene vinyl acetate, ethylene ethyl acetate, polyethylene, polyethylene terephthalate, polypropylene, polycarbonate, polyimide, polyethylene naphthalate, polyphenylene sulfide, polyester, polystyrene, and copolymers thereof, dielectric laminate, bisphenol A laminate, fiberglass laminate, paper, cellulosic paper, synthetic paper, metal, metal foils, glass, silica, silicate, and combinations thereof.

21. The method of claim 12 comprising the step of forming a conductive trace by drying the conductive ink.

22. The method of claim 21 comprising the step of plating the conductive trace.

23. The method of claim 12 comprising the step of coating a surface of the circuit element with a protective coating.
